# EUROPEAN PATENT SPECIFICATION

(11) **EP 4 213 150 B1**
(45) Date of publication and mention of the grant of the patent: **01.01.2025**
(21) Application number: 20958378.0
(22) Date of filing: 23.10.2020
(51) Int. Cl.: G11C 7/06, G11C 11/4097

(54) **MEMORY AND DATA MIGRATION METHOD**
SPEICHER UND DATENMIGRATIONSVERFAHREN
MÉMOIRE ET PROCÉDÉ DE MIGRATION DE DONNÉES

(43) Date of publication of application: 19.07.2023
(73) Proprietor: Huawei Technologies Co., Ltd., Shenzhen, Guangdong 518129 (CN)
(72) Inventor: JING, Weiliang, Shenzhen, Guangdong 518129 (CN); WANG, Zhengbo, Shenzhen, Guangdong 518129 (CN); CUI, Jingjie, Shenzhen, Guangdong 518129 (CN)
(74) Representative: Goddar, Heinz J.
(86) International application number: PCT/CN2020/123446
(87) International publication number: WO 2022/082796

(56) References cited:
- CN-A- 1 220 464
- CN-A- 108 701 473
- US-A1- 2004 170 075
- US-A1- 2016 035 402
- US-B2- 6 452 832

## Description

### TECHNICAL FIELD

This application relates to the storage field, and in particular, to a memory and a data migration method.

### BACKGROUND

A dynamic random access memory (dynamic random access memory, DRAM) is a common random access memory, and is widely used in the storage field. In a new non-Von Neumann computing architecture, data does not need to be exchanged between a processor and a memory in in-memory computing (computing is directly performed in the memory), to greatly reduce a delay and energy consumption. Therefore, in-memory computing attracts much attention.

Currently, the DRAM includes a plurality of memory banks, each bank includes a plurality of memory cell subarrays, and each subarray includes memory cells (memory cell, MC, which is a cell for short) disposed in an array. Each MC is connected to several word lines (word line, WL) and bit lines (bit line, BL), and there are a plurality of sense amplifiers (sense amplifier, SA) between adjacent subarrays. A positive input (BL) and a negative input (B̅L̅ ) of each SA are respectively connected to bit lines of MCs in two adjacent subarrays. Each subarray includes Y BLs. An input/output data bus of each bank has X bits, and Y is greater than or equal to X.

Document US2004/170075 describes a prior art DRAM.

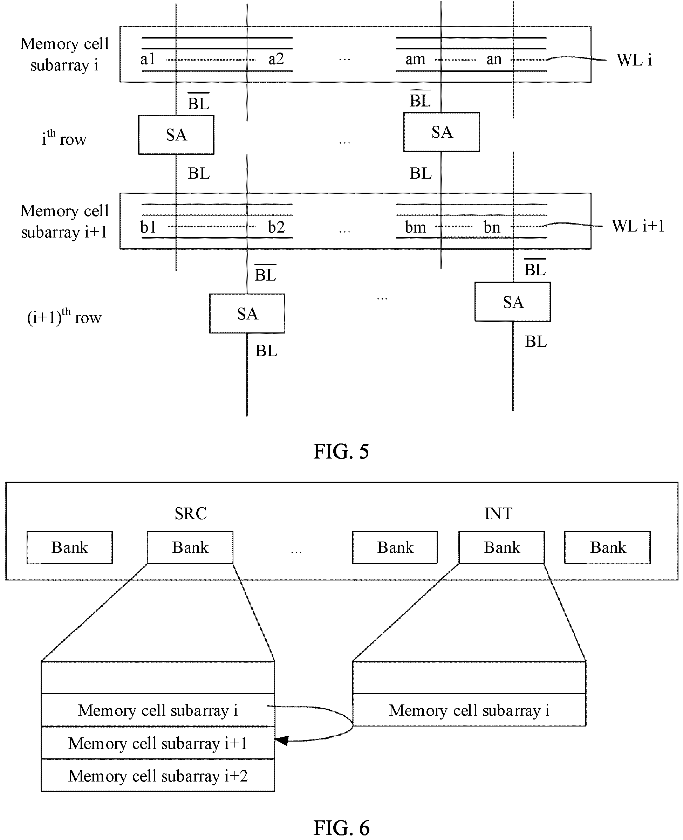

In the DRAM, mass batch bitwise logical operations are invoked as basic operators of in-memory computing. For example, when bitwise logical operations such as AND and OR (AND & OR) operations are performed on data of vectors a[1, 2 ... m, n] (where when one memory cell stores 1-bit data, the vector a is data stored in a row of memory cells, and a data bit width is 128/256/512 bits) and vectors b[1, 2 ... m, n] (a data bit width is 128/256/512 bits) in a subarray i and a subarray i+1 (as shown in FIG. 5) of two adjacent memory cell subarrays in the bank of the DRAM, the data needs to be placed in a same subarray. Therefore, data migration is required.

During data migration (as shown in FIG. 5 and FIG. 6), a vector i and a vector i+1 are respectively mapped to MCs connected to two word lines (WL i and WL i+1) in the subarray i and the subarray i+1. Before a bitwise logical operation is performed on the two vectors, the two vectors need to be placed in a same subarray. For example, the vector i of the WL i in the subarray i needs to be migrated to the subarray i+1. In this case, a WL i in a subarray i in a bank_SRC needs to be activated first, and then data of a vector i of the WL i is sequentially read, and sequentially written into a subarray i in a bank_INT for temporary storage. Then, the data in the bank_INT is read and migrated to a subarray i+1 in the bank_SRC. In this way, data in two adjacent subarrays is placed in a same subarray and is prepared for subsequent bitwise logical operations. In a data reading process performed on the MC, one activation operation and one precharge operation need to be performed on the BL connected to the MC, and in a data writing process performed on the MC, one activation operation and one precharge operation also need to be performed on the BL connected to the MC. Therefore, when data is migrated between adjacent subarrays in a same bank according to the method, if a data bit width is Y, and a data bus bit width between different banks is X, 4Y/X activation operations and 4Y/X precharge operations need to be performed in the entire process. Consequently, the entire data transmission process is slow, energy consumption is high, and efficiency is low.

### SUMMARY

This application provides a memory and a data migration method, to reduce time for implementing data migration between adjacent memory cell subarrays during in-memory computing in a DRAM, further reduce power consumption of the memory, and improve efficiency.

According to a first aspect, a memory is provided. The memory includes several memory banks. The bank includes a plurality of memory cell subarrays disposed in a column, each memory cell subarray includes memory cells disposed in an array, memory cells located in a same row in the memory cell subarray are connected to a same word line, and memory cells located in a same column are connected to a same bit line. A sense amplifier SA and a switch unit are disposed in a row at spacings between adjacent memory cell subarrays. Between adjacent memory cell subarrays, a sense amplifier is disposed on one of every two adjacent bit lines, and the other bit line is connected to a switch unit in series. In addition, on a same bit line, the sense amplifier and the switch unit are alternately disposed between the memory cell subarrays. When any switch unit is turned on, the SA connected to two rows of memory cell subarrays can be turned on. For example, a positive input BL of a first SA connected to a column of memory cells in a memory cell subarray i+1 is connected to a negative input B̅L̅ of a second SA connected to a column of memory cells in a memory cell subarray i+2. Then, when the positive input BL of the first SA reads data of any memory cell in the column of memory cells in the memory cell subarray i+1, the switch unit may transmit the data read by the first SA to the second SA. Finally, the second SA writes the received data into any memory cell in the column of memory cells in the memory cell subarray i+2 connected to the second SA, to implement data migration between adjacent subarrays in a same bank without using different banks. Therefore, this can improve a speed of data transmission, reduce power consumption of data migration, and improve efficiency.

In a possible implementation, the bit line is divided into two sections by the sense amplifier disposed on the bit line, one section is connected to a positive input of the sense amplifier, and the other section is connected to a negative input of the sense amplifier.

In a possible implementation, a control end of the switch unit is connected to one word line, and when the switch unit is turned on by a control signal of the control end, the switch unit is configured to conduct a sense amplifier in a previous row and a sense amplifier in a next row, to transmit data between the sense amplifier in the previous row and the sense amplifier in the next row.

In a possible implementation, the switch unit includes a switch transistor, and a source of the switch transistor and a drain of the switch transistor are respectively connected to bit lines of the adjacent memory cell subarrays. In this solution, the switch unit is mainly implemented by using a switch transistor. Because the memory cell includes an access transistor, the switch unit may alternatively be implemented in a form of a transistor. This facilitates production by using a same manufacturing process.

In a possible implementation, the memory further includes a word line control circuit, and the word line control circuit is connected to the control end of the switch unit through the word line, and is configured to input the control signal to the control end of the switch unit.

In a possible implementation, the sense amplifier includes the switch unit.

In a possible implementation, the memory cell includes an access transistor and a storage capacitor, one end of the storage capacitor is connected to a source line, the other end of the storage capacitor is connected to a first end of the access transistor, a second end of the access transistor is connected to the bit line, and a control end of the access transistor is connected to the word line.

According to a second aspect, a data migration method for the memory in the first aspect is provided. The method includes: reading, by a first sense amplifier, data of a first memory cell in a first memory cell subarray, where a first end of the first sense amplifier is connected to the first memory cell through a first bit line; controlling a switch unit to be turned on, and writing the data of the first memory cell into a second sense amplifier, where a first end of the switch unit is connected to the first end of the first sense amplifier through the first bit line, and a second end of the switch unit is connected to a second end of the second sense amplifier through a second bit line; and writing the data of the first memory cell into a second memory cell in a second memory cell subarray by using the second sense amplifier, where the second end of the second sense amplifier is connected to the second memory cell through the second bit line; and the first end of the first sense amplifier is a positive input, and the second end of the second sense amplifier is a negative input; or the first end of the first sense amplifier is a negative input, and the second end of the second sense amplifier is a positive input.

In a possible implementation, the first memory cell is further connected to a first word line, and before the reading, by a first sense amplifier, data of a first memory cell in a first memory cell subarray, the method further includes: activating the first word line.

In a possible implementation, the second memory cell is further connected to a second word line, and before the writing, by the second sense amplifier, the data of the first memory cell into a second memory cell in a second memory cell subarray, the method further includes: activating the second word line.

In a possible implementation, after the writing, by the second sense amplifier, the data of the first memory cell into a second memory cell in a second memory cell subarray, the method further includes: turning off the switch unit; and precharging the first bit line and the second bit line.

According to a third aspect, an integrated circuit is provided, and is applied to the memory in the first aspect. The integrated circuit includes a memory controller and a memory interface. The memory controller is configured to: read data of a first memory cell in a first memory cell subarray by using a first sense amplifier, where a first end of the first sense amplifier is connected to the first memory cell through a first bit line; control a switch unit to be turned on, and write the data of the first memory cell into a second sense amplifier, where a first end of the switch unit is connected to the first end of the first sense amplifier through the first bit line, and a second end of the switch unit is connected to a second end of the second sense amplifier through a second bit line; and write the data of the first memory cell into a second memory cell in a second memory cell subarray by using the second sense amplifier, where the second end of the second sense amplifier is connected to the second memory cell through the second bit line; and the first end of the first sense amplifier is a positive input, and the second end of the second sense amplifier is a negative input; or the first end of the first sense amplifier is a negative input, and the second end of the second sense amplifier is a positive input.

In a possible implementation, the first memory cell is further connected to a first word line, and the memory controller is further configured to: before reading the data of the first memory cell in the first memory cell subarray by using the first sense amplifier, activate the first word line.

In a possible implementation, the second memory cell is further connected to a second word line, and the memory controller is further configured to: before writing the data of the first memory cell into the second memory cell in the second memory cell subarray by using the second sense amplifier, activate the second word line.

In a possible implementation, the memory controller is further configured to: after writing the data of the first memory cell into the second memory cell in the second memory cell subarray by using the second sense amplifier, turn off the switch unit; and precharge the first bit line and the second bit line.

According to a fourth aspect, an electronic device is provided, and includes the integrated circuit and the memory. The integrated circuit includes a memory controller and a memory interface, and the memory is connected to the memory controller through the memory interface.

For technical effects brought by the second aspect to the fourth aspect, refer to technical effects brought by different implementations of the first aspect. Details are not described herein again.

### BRIEF DESCRIPTION OF DRAWINGS

FIG. 1 is a schematic diagram of an architecture of a computer system according to an embodiment of this application;
FIG. 2 is a schematic diagram of an architecture of a memory according to an embodiment of this application;
FIG. 3 is a schematic diagram of a circuit structure of a memory cell subarray according to an embodiment of this application;
FIG. 4 is a schematic diagram of circuit structures of a memory cell subarray and a sense amplifier according to an embodiment of this application;
FIG. 5 is a schematic diagram of a structure of a memory according to an embodiment of this application;
FIG. 6 is a schematic diagram of a data migration process of a memory according to an embodiment of this application;
FIG. 7 is a schematic diagram of a structure of a memory according to another embodiment of this application;
FIG. 8 is a schematic diagram of a data migration method according to an embodiment of this application;
FIG. 9 is a schematic diagram of a data migration method according to another embodiment of this application;
FIG. 10 is a schematic diagram of a data migration method according to still another embodiment of this application;
FIG. 11 is a schematic diagram of a data migration method according to yet another embodiment of this application;
FIG. 12 is a schematic diagram of a structure of a data migration apparatus according to an embodiment of this application; and
FIG. 13 is a schematic diagram of a structure of an integrated circuit according to an embodiment of this application.

### DESCRIPTION OF EMBODIMENTS

Construction and practice of various embodiments are discussed in detail below. However, it should be understood that a plurality of applicable inventive concepts provided in this application can be implemented in a plurality of specific environments. The specific embodiments discussed are merely illustrative of specific manners to implement and use the specification and the technologies, and do not limit the scope of this application.

Unless defined otherwise, all technical and scientific terms used herein have the same meaning as commonly understood by a person of ordinary skill in the art to which this disclosure belongs.

Each circuit or another component may be described as or referred to as "configured to" perform one or more tasks. In this case, "configured to" is used to imply a structure by indicating that the circuit/component includes a structure (for example, a circuit system) that performs one or more tasks during operation. Therefore, the circuit/component can be referred to as being configured to perform the task even when the specified circuit/component is not currently operational (for example, is not on). The circuit/component used with the term "configured to" includes hardware, for example, a circuit that performs an operation.

The following describes technical solutions in embodiments of this application with reference to the accompanying drawings in embodiments of this application. In this application, "at least one" means one or more, and "a plurality of" means two or more. "And/or" describes an association relationship between associated objects, and represents that three relationships may exist. For example, A and/or B may represent the following cases: Only A exists, both A and B exist, and only B exists, where A and B may be singular or plural. The character "/" usually indicates an "or" relationship between the associated objects. At least one of the following items (pieces) or a similar expression thereof refers to any combination of these items, including any combination of singular items (pieces) or plural items (pieces). For example, at least one of a, b, or c may represent: a, b, c, a and b, a and c, b and c, or a, b, and c, where a, b, and c may be singular or plural. In addition, in embodiments of this application, the terms such as "first" and "second" are not intended to limit a quantity or an execution sequence.

It should be noted that, in this application, the word such as "example" or "for example" is used to represent giving an example, an illustration, or a description. Any embodiment or design scheme described as "example" or "for example" in this application should not be explained as having more advantages than another embodiment or design scheme. Specifically, usage of the word such as "example" or "for example" is intended to present a related concept in a specific manner.

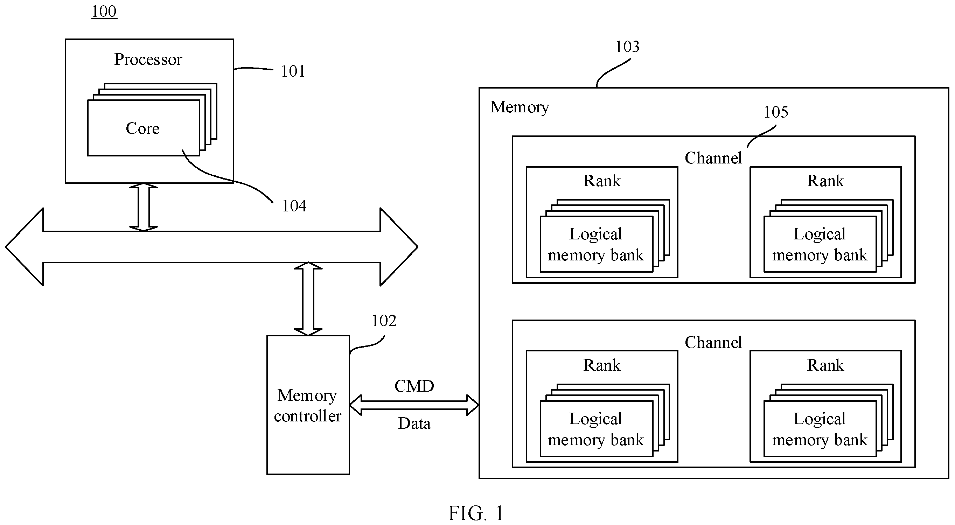

FIG. 1 is a schematic diagram of an architecture of a computer system according to an embodiment of this application. As shown in FIG. 1, a computer system 100 may include at least a processor (processor) 101, a memory controller (memory controller) 102, and a memory 103. Usually, the memory controller 102 may be integrated into the processor 101. The memory 103 may be used for internal storage. It should be noted that in the computer system provided in this embodiment of this application, in addition to the components shown in FIG. 1, the computer system 100 may further include another component such as a communication interface and a disk that is used for external storage. This is not limited herein.

The processor 101 is a computing core and a control unit (control unit) of the computer system 100. The processor 101 may include a plurality of cores (core) 104. An operating system and another software program are installed in the processor 101, to enable the processor 101 to access the memory 103, a cache, and the disk. In this embodiment of this application, the core 104 in the processor 101 may be a central processing unit (central processing unit, CPU), an artificial intelligence (artificial intelligence, AI) processor, a digital signal processor (digital signal processor), a neural network processing unit, another application-specific integrated circuit (application-specific integrated circuit, ASIC), or the like. The memory controller 102 is a bus circuit controller that controls the memory 103 inside the computer system 100 and is configured to manage and plan data transmission from the memory 103 to the core 104. The memory controller 102 may be used for data exchange between the memory 103 and the core 104. The memory controller 102 may be an independent chip, and is connected to the core 104 through a system bus. The memory controller 102 may alternatively be integrated into the processor 101, or disposed in a northbridge. A specific location of the memory controller 102 is not limited in this embodiment of this application. During actual application, the memory controller 102 may control necessary logic to write data into the memory 103 or read data from the memory 103.

The memory 103 is a main memory of the computer system 100. The memory 103 is connected to the memory controller 102 through a double data rate (double data rate, DDR) bus. The memory 103 is usually configured to store various running software in the operating system, input and output data, information exchanged with an external memory, and the like. A dynamic random access memory (dynamic random access memory, DRAM) is usually used as the memory 103. The processor 101 can access the memory 103 at a high speed by using the memory controller 102, and perform a read operation and a write operation on any memory cell in the memory 103.

In this embodiment of this application, an example in which the memory 103 is a DRAM is used for description. The memory 103 may also be referred to as a DRAM 103. Data is stored in a memory cell (which may also be referred to as a DRAM cell, MC) of the DRAM 103. In this embodiment of this application, the memory cell is a minimum memory cell configured to store data. Usually, one memory cell may store 1-bit (bit) data. The DRAM uses an amount of electricity stored in a capacitor to indicate data 0 or data 1. Because the capacitor is subject to electricity leakage, if electric charges in the capacitor are insufficient, stored data may suffer an error. Therefore, the memory controller 102 refreshes data in the DRAM 103 at regular intervals, to prevent the DRAM 103 from losing data. In addition, the DRAM 103 is volatile. When the computer system 100 is powered off, information in the DRAM 103 is absent from storage. During actual application, MCs in the DRAM 103 are arranged and disposed into a matrix, and the matrix is referred to as a memory cell subarray. One bank includes several memory cell subarrays, and the memory controller 102 can locate any bit in the bank by using corresponding row and column decoders. One DRAM chip (which may also be referred to as a memory chip) may include a plurality of banks, and one rank may include a plurality of DRAM chips. A plurality of DRAM ranks may alternatively be integrated into a dual in-line memory module (dual in-line memory module, DIMM). For example, as shown in FIG. 1, the DRAM 103 may include a plurality of channels (channel) 105. Each channel 105 may include at least one rank, and each rank may include at least one bank. Each bank includes a plurality of memory cell subarrays. A person skilled in the art may learn that the rank is memory chips (chip) connected to a same chip select (chip select) signal. The memory controller 102 can perform a write operation on chips in a same rank, and chips in a same rank also share a same control signal. The memory controller 102 may access data in memory cells in each channel of the DRAM 103 by using a memory bus.

During actual application, the memory cell is separately connected to a word line (word line, WL) and a bit line (bit line, BL), the word line is connected to a plurality of memory cells in a horizontal direction, and the bit line is connected to a plurality of memory cells in a vertical direction. The word line is used to enable the memory cell, and the bit line is used to charge a capacitor in each memory cell, so that the amount of electricity stored in the capacitor can be used to indicate the data 0 and the data 1. It may be understood that, when the bit line is at a high level, a large amount of electricity is stored in the capacitor, or a large quantity of charges are stored in the capacitor. When the bit line is at a low level, a small amount of electricity is stored in the capacitor, or a small quantity of charges are stored in the capacitor. During application, in one case, a large quantity of charges in the capacitor may indicate that data "1" is stored in the memory cell, and a small quantity of charges indicate that data "0" is stored. In another case, a large quantity of charges in the capacitor may alternatively indicate that data "0" is stored, and a small quantity of charges indicate that data "1" is stored.

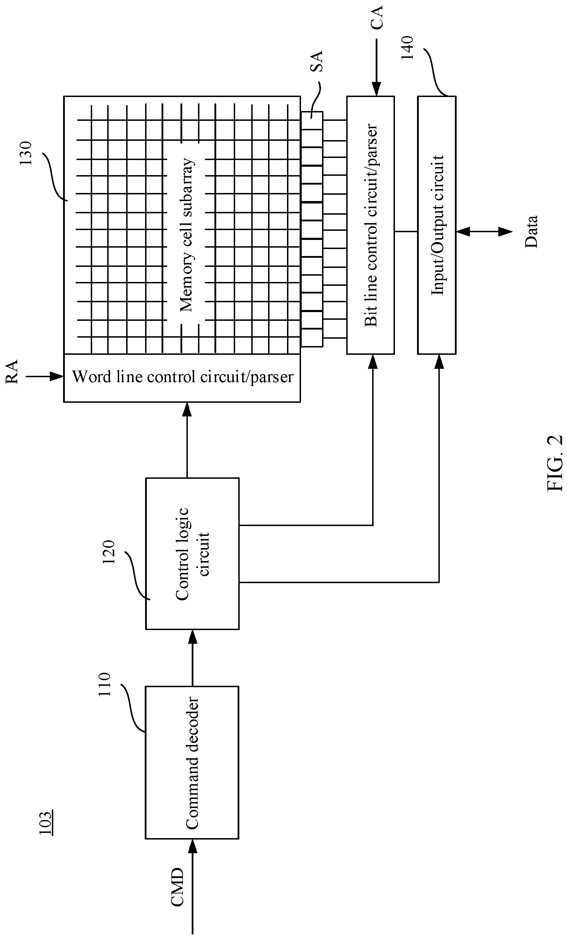

Refer to FIG. 2. The memory 103 may include a command decoder 110, a control logic circuit 120, a memory cell subarray 130, and an input/output circuit 140. This is not limited in a specific embodiment. More or fewer components may be included. The command decoder 110 may receive a command CMD (command, CMD) from the memory controller 102, and may decode the received command CMD. For example, the command CMD may include a write command (write, WR), a read command (read, RD), an active command (active, ACT), and/or a precharge command (precharge, PRE).

The memory cell subarray 130 may include a plurality of memory cells MC. The plurality of MCs may be connected to a plurality of word lines and a plurality of bit lines. The word line may be connected to a word line control circuit (which is also referred to as a word line parser), and the bit line may be connected to a bit line control circuit (which is also referred to as a bit line parser). The control logic circuit 120 may control the components of the memory 103 based on a decoding result from the command decoder 110. For example, when the decoding result of the command decoder 110 indicates that the received command CMD is an active command ACT, the control logic circuit 120 may control the word line control circuit to activate a word line corresponding to a row address (row address, RA) received together with the active command ACT. Then, data stored in the memory cell MC connected to the activated word line may be set (for example, transmitted, sent, or output) by using a sense amplifier (sense amplifier, SA) to the input/output circuit 140. For example, when the decoding result of the command decoder 110 indicates that the received command CMD is a read command RD, the control logic circuit 120 may control the input/output circuit 140 to output data from a bit line corresponding to a column address (column address, CA) received together with the read command RD. When the decoding result of the command decoder 110 indicates that the received command CMD is a write command WR, the control logic circuit 120 may set write data received from the memory controller 102 to the input/output circuit 140. The memory controller 102 may send a precharge command PRE to the memory 103, to deactivate and/or disable the activated word line. For example, when the decoding result of the command decoder 110 indicates that the received command CMD is a precharge command PRE, the control logic circuit 120 may control the input/output circuit 140 and the bit line control circuit to precharge the bit line. The foregoing briefly describes basic principles of operations such as activation, read, write, and precharge. It may be understood that the operations such as activation, read, write, and precharge in the following solutions may be implemented in at least the manners described above.

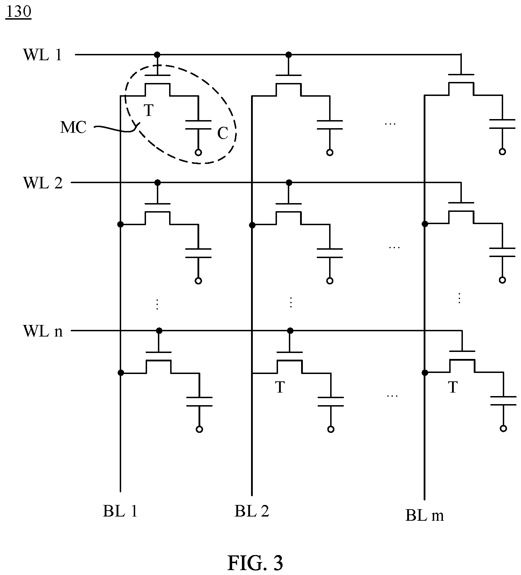

FIG. 3 shows a diagram of a circuit of the memory cell subarray 130 in FIG. 2. The memory cell subarray 130 may include a plurality of memory cells MC. Each memory cell MC may include an access transistor T and a storage capacitor C. A first end of the access transistor T of the memory cell MC is connected to one of a bit line BL 1 to a bit line BL m, and a second end of the access transistor T is connected to a first end of the storage capacitor C. A gate of the access transistor T is connected to one of a word line WL 1 to a word line WL n. A second end of the storage capacitor C may be connected to a voltage terminal. The voltage terminal may be connected to a voltage (for example, ground or a half-power supply voltage) of a specific level (for example, an expected voltage level) through a source line (source line, SL). In some embodiments, when any one of the word line WL 1 to the word line WL n is selected in response to the active command ACT from the memory controller 102, and the selected word line can be activated, data stored in a memory cell connected to the selected word line may be provided to the input/output circuit 140 through the plurality of bit lines BL 1 to BL m and the SA.

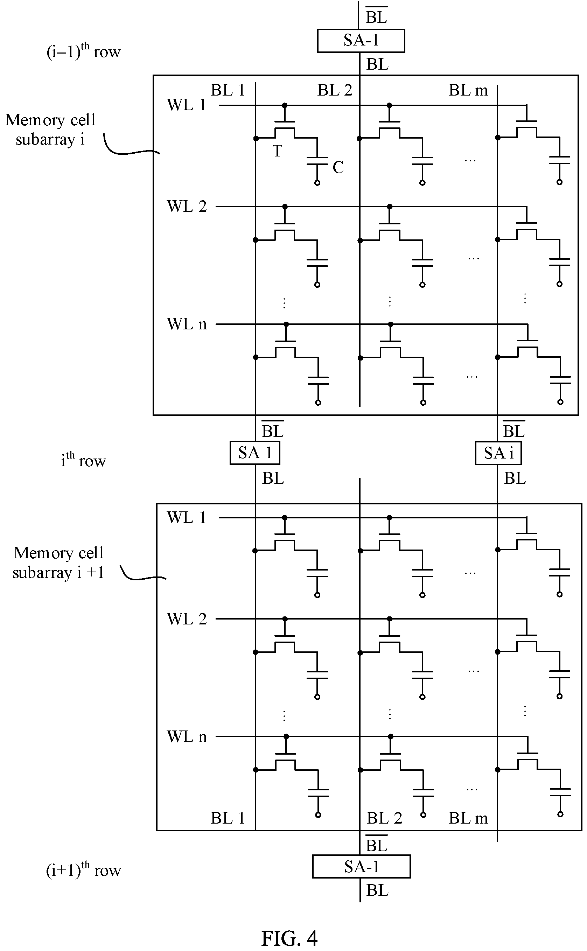

In addition, as shown in FIG. 4, a positive input BL and a negative input B̅L̅ of the sense amplifier SA are respectively connected to two bit lines of two adjacent memory cell subarrays: a subarray i and a subarray i+1. For example, a BL 1 in the subarray i is connected to a negative input B̅L̅ of a sense amplifier SA 1 in an i^{th} row, and a BL 1 in the subarray i+1 is connected to a positive input BL of a sense amplifier SA i in an i^{th} row. After a word line WL i in any row in the subarray i+1 is activated, the sense amplifier SA reads, through the positive input BL, data from a memory cell connected to the WL i in the memory cell subarray i+1. Alternatively, as shown in FIG. 2, the input/output circuit 140 writes data into the memory cell through the corresponding BL 1. Because structures of memory cells are all the same, in the following example, the memory cell subarray is simplified as a diagram shown in FIG. 5 in which a word line and a bit line intersect. It can be understood that there is one memory cell at an intersection between each word line and each bit line.

Based on the memory, during data migration (as shown in FIG. 5 and FIG. 6), for example, a vector i of the WL i in the subarray i needs to be migrated to the subarray i+1. In this case, a WL i in a subarray i in a bank_SRC needs to be activated first, and then data a[1, 2 ... m, n] of a vector i of the WL i is sequentially read, and sequentially written into a subarray i in a bank_INT for temporary storage. Then, the data in the bank_INT is read and migrated to a subarray i+1 in the bank_SRC. In this way, data in two adjacent subarrays is placed in a same subarray and is prepared for subsequent bitwise logical operations. When data is migrated between adjacent subarrays in a same bank according to the method, if a data bit width is Y, and a data bus bit width between different banks is X, 4Y/X activation operations and 4Y/X precharge operations need to be performed in the entire process. Consequently, the entire data transmission process is slow, energy consumption is high, and efficiency is low.

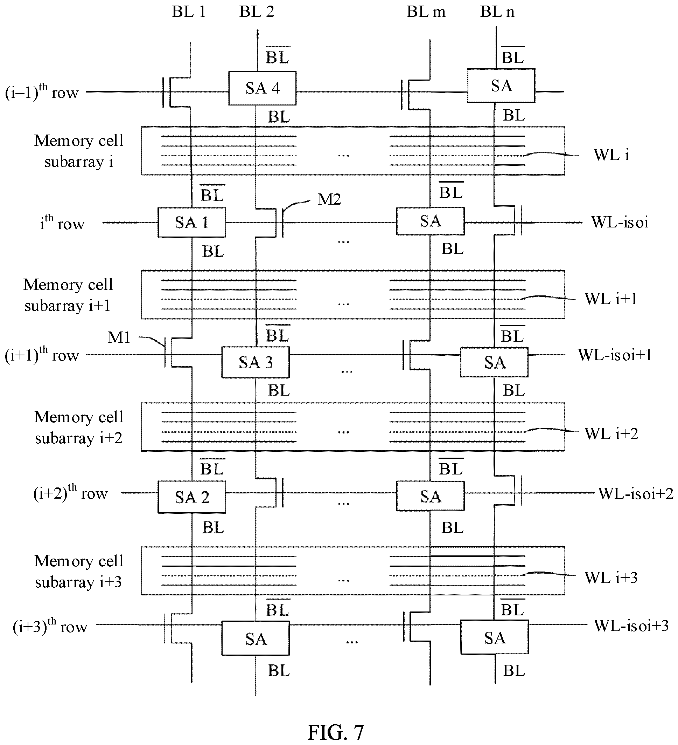

To resolve the foregoing problems, a memory is provided. The memory includes several memory banks. As shown in FIG. 7, the bank includes a plurality of memory cell subarrays (a subarray i to a subarray i+3 shown in FIG. 7) disposed in a column, each memory cell subarray includes memory cells disposed in an array, memory cells located in a same row in the memory cell subarray are connected to a same word line, and memory cells located in a same column are connected to a same bit line (connection manners between the memory cell and the word line and between the memory cell and the bit line are shown in FIG. 3 and FIG. 4). As shown in FIG. 7, a sense amplifier SA and a switch unit M are disposed in a row at spacings between adjacent memory cell subarrays, each sense amplifier SA corresponds to a column of memory cells MC, and each switch unit M corresponds to another column of memory cells MC. A positive input BL and a negative input B̅L̅ of the sense amplifier SA are respectively connected to bit lines of first columns of memory cells in two adjacent memory cell subarrays, and two ends of the switch unit M are respectively connected to bit lines of second columns of memory cells in two adjacent memory cell subarrays. In a direction of a same column of memory cells, the sense amplifier SA and the switch unit M are disposed at spacings between the memory cell subarrays.

FIG. 7 is described by using an example of two adjacent rows of memory cell subarrays: a subarray i and a subarray i+1. A sense amplifier SA and a switch unit M are disposed in a row (an i^{th} row) at spacings between the subarray i and the subarray i+1. Between adjacent memory cell subarrays, a sense amplifier is disposed on one of every two adjacent bit lines, and the other bit line is connected to a switch unit in series. For example, the bit line is divided into two sections by the sense amplifier SA disposed on the bit line, one section is connected to a positive input BL of the sense amplifier SA, and the other section is connected to a negative input B̅L̅ of the sense amplifier. A sense amplifier SA 1 and a switch unit M2 in the i^{th} row are used as an example. The sense amplifier SA 1 divides a bit line BL 1 into a section in the subarray i+1 and a section in the subarray i. Then, a positive input BL of the sense amplifier SA 1 is connected to a bit line BL 1 of a first column of memory cells MC in the subarray i+1, and a negative input B̅L̅ of the sense amplifier SA 1 is connected to a bit line BL 1 of a first column of memory cells MC in the subarray i. One end of the switch unit M2 is connected to a bit line BL 2 of a second column of memory cells MC in the subarray i+1, and the other end of the switch unit M2 is connected to a bit line BL 2 of a second column of memory cells MC in the subarray i. In a direction of memory cells in a same column as the SA 1, one end of a switch unit M1 between the subarray i+1 and a subarray i+2 is connected to the bit line BL 1 of the first column of memory cells MC in the subarray i+1, and the other end of the switch unit M1 is connected to a bit line BL 1 of a first column of memory cells MC in the subarray i+2. On a same bit line, the sense amplifier and the switch unit are alternately disposed between the memory cell subarrays. For example, in a direction of a bit line BL 1 of a first column of memory cells MC in each subarray, the sense amplifier SA 1 is located between the subarray i and the subarray i+1, the switch unit M1 is located between the subarray i+1 and the subarray i+2, and a sense amplifier SA 2 is located between the subarray i+2 and a subarray i+3.

When any switch unit is turned on, the SA connected to two rows of memory cell subarrays can be turned on. For example, a positive input BL of a first SA connected to a column of memory cells in the memory cell subarray i+1 is connected to a negative input B̅L̅ of a second SA connected to a column of memory cells in the memory cell subarray i+2. In this case, when the positive input BL of the first SA reads data of any memory cell in the column of memory cells in the memory cell subarray i+1, the switch unit may transmit the data read by the first SA to the second SA. Finally, the second SA writes the received data into any memory cell in the column of memory cells in the memory cell subarray i+2 connected to the second SA, to implement data migration between adjacent subarrays in a same bank without using different banks. Therefore, this can improve a speed of data transmission, reduce power consumption of data migration, and improve efficiency.

A control end of the switch unit M is connected to one word line. As shown in FIG. 7, the control end of the switch unit in the i^{th} row is connected to a word line WL-isoi, and a control end of a switch unit in an (i+1)^{th} row is connected to a word line WL-isoi+1. When the switch unit is turned on by a control signal of the control end, the switch unit is configured to conduct a sense amplifier in a previous row and a sense amplifier in a next row, to transmit data between the sense amplifier in the previous row and the sense amplifier in the next row. In addition, the control end of the switch unit may be connected to a word line control circuit through a word line, and the word line control circuit may be the word line control circuit shown in FIG. 2. The word line control circuit is configured to input the control signal to the control end of the switch unit M.

As shown in FIG. 7, the switch unit M includes a switch transistor, and a source of the switch transistor and a drain of the switch transistor are respectively connected to bit lines of the adjacent memory cell subarrays. For example, a source of a switch transistor M1 between the subarray i+1 and the subarray i+2 is connected to the bit line BL 1 of the first column of memory cells MC in the subarray i+1, and a drain of the switch transistor M1 is connected to the bit line BL 1 of the first column of memory cells MC in the subarray i+2. Alternatively, a drain of a switch transistor M1 is connected to the bit line BL 1 of the first column of memory cells MC in the subarray i+1, and a source of the switch transistor M1 is connected to the bit line BL 1 of the first column of memory cells MC in the subarray i+2. A gate of the switch transistor M1 serves as the control end, and is connected to the word line WL-isoi+1. In this solution, the switch unit is mainly implemented by using a switch transistor. Because the memory cell includes an access transistor, the switch unit may alternatively be implemented in a form of a transistor. This facilitates production by using a same manufacturing process.

In some examples, the sense amplifier SA usually uses a circuit including a plurality of transistors that are connected, the switch unit usually uses a switch transistor, and the sense amplifier and the switch unit are similar in manufacturing processes. Therefore, the switch unit M may be integrated into the sense amplifier SA, and the sense amplifier SA includes the switch unit M.

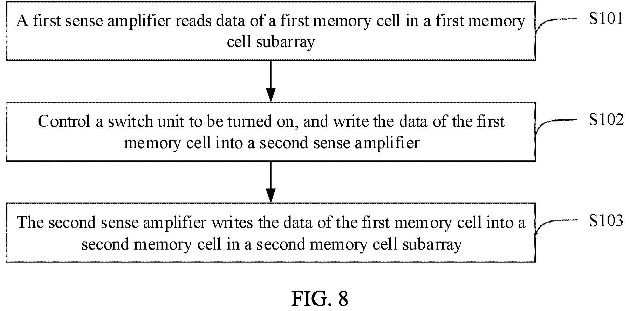

Based on the memory shown in FIG. 7, an embodiment of this application provides a data migration method. As shown in FIG. 8, the following describes the method.

S101: A first sense amplifier reads data of a first memory cell in a first memory cell subarray, where a first end of the first sense amplifier is connected to the first memory cell through a first bit line.

S102: Control a switch unit to be turned on, and write the data of the first memory cell into a second sense amplifier, where a first end of the switch unit is connected to the first end of the first sense amplifier through the first bit line, and a second end of the switch unit is connected to a second end of the second sense amplifier through a second bit line.

S103: The second sense amplifier writes the data of the first memory cell into a second memory cell in a second memory cell subarray, where the second end of the second sense amplifier is connected to the second memory cell through the second bit line.

The first end of the first sense amplifier is a positive input, and the second end of the second sense amplifier is a negative input; or the first end of the first sense amplifier is a negative input, and the second end of the second sense amplifier is a positive input.

With reference to the memory shown in FIG. 3 and FIG. 4, the memory cell is further connected to a word line. With reference to the foregoing descriptions, after the word line connected to the memory cell is activated, data may be read from or written into the memory cell. Therefore, the first memory cell is further connected to a first word line. Optionally, before step S101, the first word line needs to be activated. The second memory cell is further connected to a second word line. Optionally, before step S102, the second word line needs to be activated. After step S103, the switch unit is turned off, and the first bit line and the second bit line are precharged.

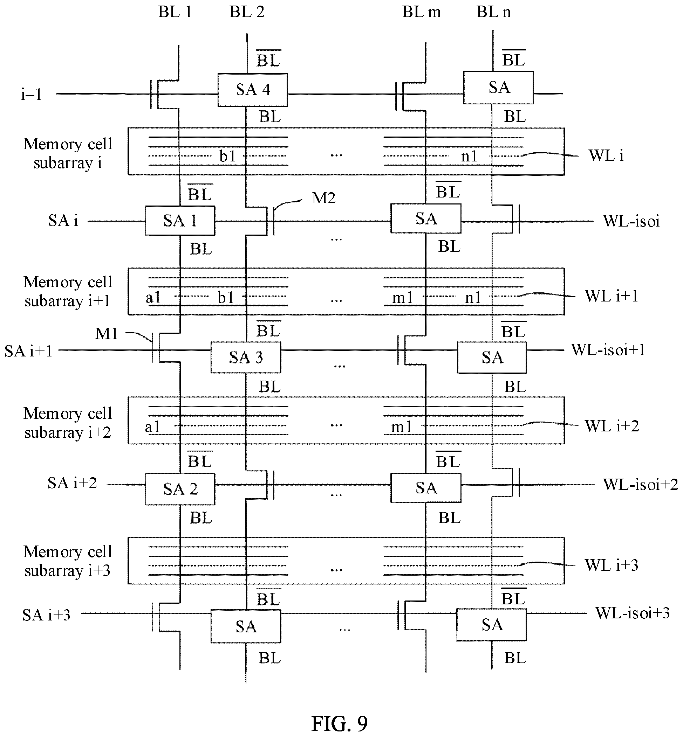

Specifically, with reference to FIG. 9, FIG. 10, and FIG. 11, a data migration method for an odd column and an even column in a subarray i+1 is specifically described as follows:

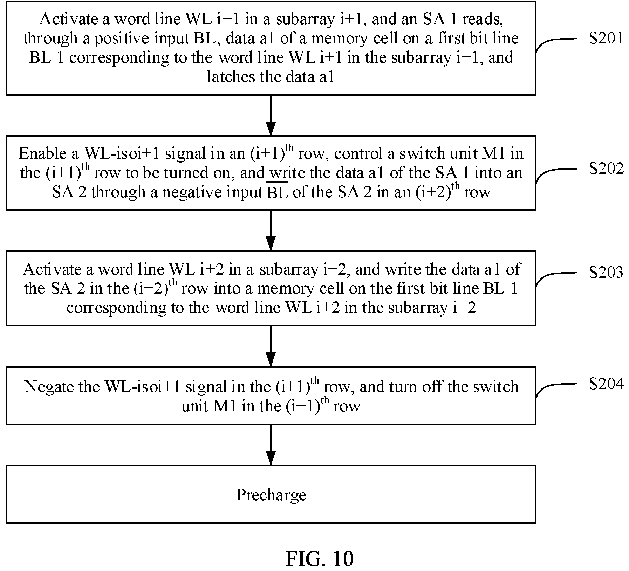

The following is described by using an example in which data of an odd column of memory cells connected to a word line WL i+1 in the subarray i+1 is migrated to a subarray i+2. A positive input BL of an SA 1 in an i^{th} row is connected to a bit line BL 1 of a first column of memory cells in the subarray i+1, a negative input B̅L̅ of an SA 2 in an (i+2)^{th} row is connected to a bit line BL 1 of a first column of memory cells in the subarray i+2, one end of a switch unit M1 in an (i+1)^{th} row is connected to the bit line BL 1 of the first column of memory cells in the subarray i+1, and the other end of the switch unit M1 is connected to the bit line BL 1 of the first column of memory cells in the subarray i+2. Specific operation steps of data migration are as follows (details are shown in FIG. 10):

S201: Activate the word line WL i+1 in the subarray i+1, and the SA 1 reads, through the positive input BL, data a1 of a memory cell on the first bit line BL 1 corresponding to the word line WL i+1 in the subarray i+1, and latches the data a1.

An operation manner of another SA in the i^{th} row is similar to that of the SA 1. Therefore, SAs in the i^{th} row read all data (a1, ..., n1...) of memory cells on odd bit lines corresponding to the word line WL i+1 in the subarray i+1.

S202: Enable a WL-isoi+1 signal in the (i+1)^{th} row, control a switch unit M1 in the (i+1)^{th} row to be turned on, and write the data a1 of the SA 1 into the SA 2 through the negative input of the SA 2 in the (i+2)^{th} row.

Another switch unit M in the (i+1)^{th} row is also turned on under control of the WL-isoi+1 signal. An operation manner of another SA in the (i+2)^{th} row is similar to that of the SA 2. Therefore, SAs in the (i+2)^{th} row write all the data (a1, ..., n1...) of the memory cells on the odd bit lines corresponding to the word line WL i+1 in the subarray i+1.

S203: Activate a word line WL i+2 in the subarray i+2, and write the data a1 of the SA 2 in the (i+2)^{th} row into a memory cell on the first bit line BL 1 corresponding to the word line WL i+2 in the subarray i+2.

An operation manner of another SA in the (i+2)^{th} row is similar to that of the SA 2. Therefore, the SAs in the (i+2)^{th} row write all the data (a1, ..., n1...) into the memory cells on the odd bit lines corresponding to the word line WL i+2 in the subarray i+2.

S204: Negate the WL-isoi+1 signal in the (i+1)^{th} row, and turn off the switch unit M1 in the (i+1)^{th} row.

Another switch unit M in the (i+1)^{th} row may also be turned off under control of the negated WL-isoi+1 signal.

Finally, precharge is performed on a bit line connected to a positive input BL of each SA in the i^{th} row and a bit line connected to a negative input B̅L̅ of each SA in the (i+2)^{th} row.

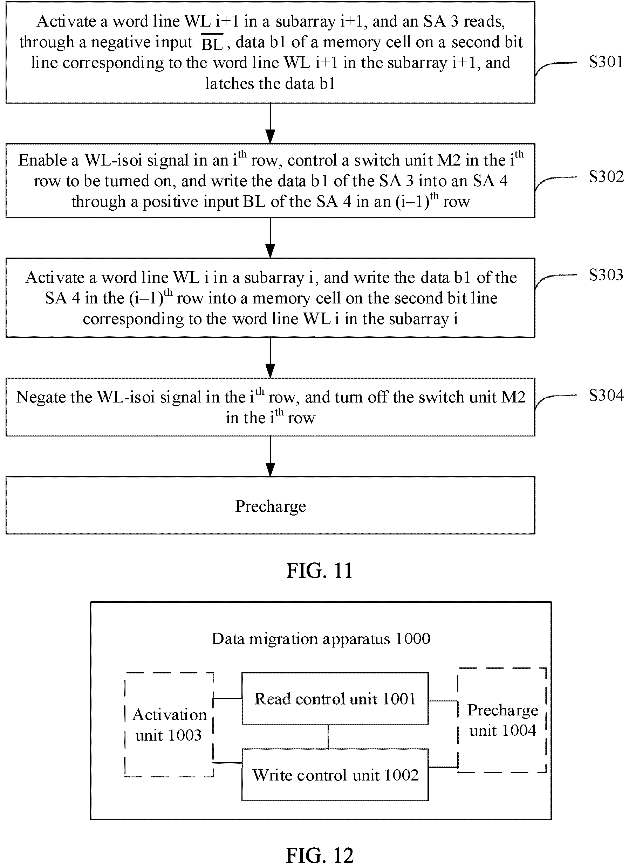

The following is described by using an example in which data of an even column of memory cells connected to a word line WL i+1 in the subarray i+1 is migrated to a subarray i. A negative input B̅L̅ of an SA 3 in an (i+1)^{th} row is connected to a bit line BL 2 of a second column of memory cells in the subarray i+1, a positive input BL of an SA 4 in an (i-1)^{th} row is connected to a bit line BL 2 of a second column of memory cells in the subarray i, one end of a switch unit M2 in an i^{th} row is connected to the bit line BL 2 of the second column of memory cells in the subarray i+1, and the other end of the switch unit M2 is connected to the word line BL 2 of the second column of memory cells in the subarray i. Specific operation steps of data migration are as follows (details are shown in FIG. 11):

S301: Activate the word line WL i+1 in the subarray i+1, and the SA 3 reads, through the negative input B̅L̅ , data b1 of a memory cell on the second bit line corresponding to the word line WL i+1 in the subarray i+1, and latches the data b1.

An operation manner of another SA in the (i+1)^{th} row is similar to that of the SA 3. Therefore, SAs in the (i+1)^{th} row read all data (b1, ..., m1...) of memory cells on even bit lines corresponding to the word line WL i+1 in the subarray i+1.

S302: Enable a WL-isoi signal in the i^{th} row, control a switch unit M2 in the i^{th} row to be turned on, and write the data b1 of the SA 3 into the SA 4 through the positive input BL of the SA 4 in the (i-1)^{th} row.

Another switch unit M in the i^{th} row is also turned on under control of the WL-isoi signal. An operation manner of another SA in the (i-1)^{th} row is similar to that of the SA 4. Therefore, SAs in the (i-1)^{th} row write all the data (b1, ..., m1...) of the memory cells on the even bit lines corresponding to the word line WL i+1 in the subarray i+1.

S303: Activate a word line WL i in the subarray i, and write the data b1 of the SA 4 in the (i-1)^{th} row into a memory cell on the second bit line corresponding to the word line WL i in the subarray i.

An operation manner of another SA in the (i-1)^{th} row is similar to that of the SA 4. Therefore, the SAs in the (i-1)^{th} row write all the data (b1, ..., m1...) into the memory cells on the even bit lines corresponding to the word line WL i in the subarray i.

S304: Negate the WL-isoi signal in the i^{th} row, and turn off the switch unit M2 in the i^{th} row.

Another switch unit M in the i^{th} row may also be turned off under control of the negated WL-isoi signal.

Finally, precharge is performed on a bit line that is connected to a positive input BL of each SA in the (i-1)^{th} row and connected to a negative input B̅L̅ of each SA in the (i+1)^{th} row.

After the foregoing steps, data migration between adjacent memory cell subarrays can be successfully implemented in in-memory computing in the DRAM. In the existing DRAM structure, when data is migrated between adjacent subarrays of a same bank, if a data bit width is 512b, and a data bit width between different banks is 128b, 4 × (512/128) activation operations and 4 × (512/128) precharge operations need to be performed during migration. It is assumed that it takes 35 ns to activate a WL, and 15 ns to precharge, and time for reading and writing data is ignored. In the current data solution, time required for data migration is about 4 × (512/128) × (35+15) ns, namely, 400 ns. However, only about 100 ns (including time required for two activation operations and one precharge operation) is required when the solutions provided in embodiments of this application are used. This can increase a speed of data migration by four times, further greatly reduce energy consumption, and improve efficiency.

The foregoing mainly describes the solutions provided in embodiments of this application from a perspective of the method steps. It may be understood that, to implement the foregoing functions, the computer includes a corresponding hardware structure and/or a software module for performing the function. A person skilled in the art should be easily aware that, in combination with example modules and algorithm steps described in the embodiments disclosed in this specification, this application can be implemented by a combination of hardware and computer software. A person skilled in the art may use different methods to implement the described functions for each particular application, but it should not be considered that the implementation goes beyond the scope of this application.

In the embodiments of this application, a data migration apparatus may be divided into function modules based on the foregoing method examples. For example, function modules corresponding to the functions may be obtained through division, or two or more functions may be integrated into one processing module. The integrated module may be implemented in a form of hardware, or may be implemented in a form of a software functional module. It should be noted that, in embodiments of this application, division into the modules is an example, and is merely logical function division. During actual implementation, another division manner may be used.

When each functional module is obtained through division based on corresponding function, FIG. 12 shows a data migration apparatus. The data migration apparatus may be a chip. The data migration apparatus 1000 includes:
a read control unit 1001, configured to read data of a first memory cell in a first memory cell subarray by using a first sense amplifier, where a first end of the first sense amplifier is connected to the first memory cell through a first bit line; and
a write control unit 1002, configured to: control a switch unit to be turned on, and write the data of the first memory cell into a second sense amplifier, where a first end of the switch unit is connected to the first end of the first sense amplifier through the first bit line, and a second end of the switch unit is connected to a second end of the second sense amplifier through a second bit line; and write the data of the first memory cell into a second memory cell in a second memory cell subarray by using the second sense amplifier, where the second end of the second sense amplifier is connected to the second memory cell through the second bit line; and the first end of the first sense amplifier is a positive input, and the second end of the second sense amplifier is a negative input; or the first end of the first sense amplifier is a negative input, and the second end of the second sense amplifier is a positive input.

Optionally, the first memory cell is further connected to a first word line, and the data migration apparatus further includes an activation unit 1003, configured to: before reading the data of the first memory cell in the first memory cell subarray by using the first sense amplifier, activate the first word line.

Optionally, the second memory cell is further connected to a second word line, and the activation unit 1003 is configured to: before writing the data of the first memory cell into the second memory cell in the second memory cell subarray by using the second sense amplifier, activate the second word line.

Optionally, a precharge unit 1004 is configured to: after writing the data of the first memory cell into the second memory cell in the second memory cell subarray by using the second sense amplifier, turn off the switch unit; and precharge the first bit line and the second bit line.

All related content of the steps in the foregoing method embodiments may be cited in function descriptions of corresponding functional modules. Details are not described herein again.

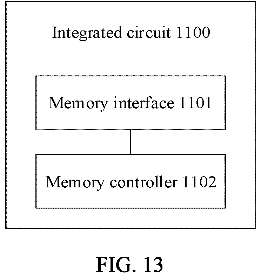

For example, an embodiment of this application further provides an integrated circuit. As shown in FIG. 13, the integrated circuit 1100 includes a memory interface 1101 and a memory controller 1102.

The memory interface 1101 is configured to communicate with another apparatus or device, for example, communicate with a memory. The memory controller 1102 is configured to: read data of a first memory cell in a first memory cell subarray by using a first sense amplifier, where a first end of the first sense amplifier is connected to the first memory cell through a first bit line; control a switch unit to be turned on, and write the data of the first memory cell into a second sense amplifier, where a first end of the switch unit is connected to the first end of the first sense amplifier through the first bit line, and a second end of the switch unit is connected to a second end of the second sense amplifier through a second bit line; and write the data of the first memory cell into a second memory cell in a second memory cell subarray by using the second sense amplifier, where the second end of the second sense amplifier is connected to the second memory cell through the second bit line; and the first end of the first sense amplifier is a positive input, and the second end of the second sense amplifier is a negative input; or the first end of the first sense amplifier is a negative input, and the second end of the second sense amplifier is a positive input.

Optionally, the first memory cell is further connected to a first word line, and the memory controller 1102 is further configured to: before reading the data of the first memory cell in the first memory cell subarray by using the first sense amplifier, activate the first word line.

Optionally, the second memory cell is further connected to a second word line, and the memory controller 1102 is further configured to: before writing the data of the first memory cell into the second memory cell in the second memory cell subarray by using the second sense amplifier, activate the second word line.

Optionally, the memory controller 1102 is further configured to: after writing the data of the first memory cell into the second memory cell in the second memory cell subarray by using the second sense amplifier, turn off the switch unit; and precharge the first bit line and the second bit line.

In view of this, an embodiment of this application further provides an electronic device, and the electronic device includes the integrated circuit and the memory. The integrated circuit includes a memory controller and a memory interface, and the memory is connected to the memory controller through the memory interface. Optionally, the electronic device is different types of user equipment or terminal devices such as the computer system, a mobile phone, a tablet computer, a wearable device, and a vehicle-mounted device. Alternatively, the electronic device may be a network device such as a base station. For related descriptions of the memory in the electronic device, refer to descriptions of the memory in the foregoing embodiments. Details are not described herein again in this embodiment of this application.

According to another aspect, this application further provides a non-transitory computer-readable storage medium used with a computer. The computer includes software for creating an integrated circuit, the computer-readable storage medium stores one or more computer-readable data structures, and the one or more computer-readable data structures include optical mask data for manufacturing the memory in any figure.

Methods or algorithm steps described in combination with the content disclosed in this application may be implemented by hardware, or may be implemented by a processor by executing a software instruction. The software instruction may include a corresponding software module. The software module may be stored in a random access memory (random access memory, RAM), a flash memory, an erasable programmable read-only memory (erasable programmable ROM, EPROM), an electrically erasable programmable read-only memory (electrically EPROM, EEPROM), a register, a hard disk, a removable hard disk, a compact disc read-only memory (CD-ROM), or any other form of storage medium known in the art. For example, a storage medium is coupled to the processor, to enable the processor to read information from the storage medium and write information into the storage medium. It is clear that the storage medium may be a component of the processor. The processor and the storage medium may be located in an ASIC.

A person skilled in the art should be aware that in the foregoing one or more examples, functions described in this application may be implemented by hardware, software, firmware, or any combination thereof. When the functions are implemented by software, the functions may be stored in a computer-readable medium or transmitted as one or more instructions or code in a computer-readable medium. The computer-readable medium includes a computer storage medium and a communication medium. The communication medium includes any medium that facilitates transmission of a computer program from one place to another. The storage medium may be any available medium accessible to a general-purpose computer or a special-purpose computer.

Finally, it should be noted that the foregoing descriptions are merely a specific implementation of this application, but is not intended to limit the protection scope of this application. Any variation or replacement within the technical scope disclosed in this application shall fall within the protection scope of this application. Therefore, the protection scope of this application shall be subject to the protection scope of the claims.

## Claims

1. A memory, comprising several memory banks, wherein the bank comprises a plurality of memory cell subarrays disposed in a column, each memory cell subarray comprises memory cells disposed in an array, memory cells located in a same row in the memory cell subarray are connected to a same word line, and memory cells located in a same column are connected to a same bit line;
a sense amplifier and a switch unit are disposed in a row at spacings between adjacent memory cell subarrays, and between adjacent memory cell subarrays, a sense amplifier is disposed on one bit line of every two adjacent bit lines, and the other bit line is connected to a switch unit in series; and
on a same bit line, the sense amplifier and the switch unit are alternately disposed between the memory cell subarrays.

2. The memory according to claim 1, wherein the bit line is divided into two sections by the sense amplifier disposed on the bit line, one section is connected to a positive input of the sense amplifier, and the other section is connected to a negative input of the sense amplifier.

3. The memory according to claim 1 or 2, wherein a control end of the switch unit is connected to one word line, and when the switch unit is turned on by a control signal of the control end, the switch unit is configured to conduct a sense amplifier in a previous row and a sense amplifier in a next row, to transmit data between the sense amplifier in the previous row and the sense amplifier in the next row.

4. The memory according to claim 3, wherein the switch unit comprises a switch transistor, and a source of the switch transistor and a drain of the switch transistor are respectively connected to bit lines of the adjacent memory cell subarrays.

5. The memory according to claim 3, further comprising a word line control circuit, wherein the word line control circuit is connected to the control end of the switch unit through the word line, and is configured to input the control signal to the control end of the switch unit.

6. The memory according to any one of claims 1 to 5, wherein the sense amplifier comprises the switch unit.

7. The memory according to any one of claims 1 to 6, wherein the memory cell comprises an access transistor and a storage capacitor, one end of the storage capacitor is connected to a source line, the other end of the storage capacitor is connected to a first end of the access transistor, a second end of the access transistor is connected to the bit line, and a control end of the access transistor is connected to the word line.

8. A data migration method for the memory according to any one of claims 1 to 7, comprising:
reading, by a first sense amplifier, data of a first memory cell in a first memory cell subarray, wherein a first end of the first sense amplifier is connected to the first memory cell through a first bit line;
controlling a switch unit to be turned on, and writing the data of the first memory cell into a second sense amplifier, wherein a first end of the switch unit is connected to the first end of the first sense amplifier through the first bit line, and a second end of the switch unit is connected to a second end of the second sense amplifier through a second bit line; and
writing, by the second sense amplifier, the data of the first memory cell into a second memory cell in a second memory cell subarray, wherein the second end of the second sense amplifier is connected to the second memory cell through the second bit line, wherein
the first end of the first sense amplifier is a positive input, and the second end of the second sense amplifier is a negative input; or the first end of the first sense amplifier is a negative input, and the second end of the second sense amplifier is a positive input.

9. The method according to claim 8, wherein the first memory cell is further connected to a first word line, and before the reading, by a first sense amplifier, data of a first memory cell in a first memory cell subarray, the method further comprises:
activating the first word line.

10. The method according to claim 8 or 9, wherein the second memory cell is further connected to a second word line, and before the writing, by the second sense amplifier, the data of the first memory cell into a second memory cell in a second memory cell subarray, the method further comprises:
activating the second word line.

11. An integrated circuit, applied to the memory according to any one of claims 1 to 7, and comprising a memory controller and a memory interface, wherein
the memory controller is configured to: read data of a first memory cell in a first memory cell subarray by using a first sense amplifier, wherein a first end of the first sense amplifier is connected to the first memory cell through a first bit line; control a switch unit to be turned on, and write the data of the first memory cell into a second sense amplifier, wherein a first end of the switch unit is connected to the first end of the first sense amplifier through the first bit line, and a second end of the switch unit is connected to a second end of the second sense amplifier through a second bit line; and write the data of the first memory cell into a second memory cell in a second memory cell subarray by using the second sense amplifier, wherein the second end of the second sense amplifier is connected to the second memory cell through the second bit line; and the first end of the first sense amplifier is a positive input, and the second end of the second sense amplifier is a negative input; or the first end of the first sense amplifier is a negative input, and the second end of the second sense amplifier is a positive input.

12. The integrated circuit according to claim 11, wherein the first memory cell is further connected to a first word line, and the memory controller is further configured to: before reading the data of the first memory cell in the first memory cell subarray by using the first sense amplifier, activate the first word line.

13. The integrated circuit according to claim 11 or 12, wherein the second memory cell is further connected to a second word line, and the memory controller is further configured to: before writing the data of the first memory cell into the second memory cell in the second memory cell subarray by using the second sense amplifier, activate the second word line.

14. The integrated circuit according to any one of claims 11 to 13, wherein the memory controller is further configured to: after writing the data of the first memory cell into the second memory cell in the second memory cell subarray by using the second sense amplifier, turn off the switch unit; and precharge the first bit line and the second bit line.

15. An electronic device, comprising the integrated circuit according to any one of claims 11 to 14 and the memory according to any one of claims 1 to 7, wherein the integrated circuit comprises a memory controller and a memory interface, and the memory is connected to the memory controller through the memory interface.

## Patentansprüche

1. Speicher, umfassend mehrere Speicherbänke, wobei die Bank eine Vielzahl von in einer Spalte angeordneten Speicherzellen-Subarrays umfasst, jedes Speicherzellen-Subarray in einem Array angeordnete Speicherzellen umfasst, Speicherzellen, die sich in der gleichen Zeile in dem Speicherzellen-Subarray befinden, mit derselben Wortleitung verbunden sind und Speicherzellen, die sich in derselben Spalte befinden, mit derselben Bitleitung verbunden sind;
ein Leseverstärker und eine Schalteinheit in einer Reihe in Abständen zwischen benachbarten Speicherzellen-Subarrays angeordnet sind, und ein Leseverstärker zwischen benachbarten Speicherzellen-Subarrays auf einer Bitleitung von jeweils zwei benachbarten Bitleitungen angeordnet ist und die andere Bitleitung in Reihe mit einer Schalteinheit verbunden ist; und der Leseverstärker und die Schalteinheit auf derselben Bitleitung abwechselnd zwischen den Speicherzellen-Subarrays angeordnet sind.

2. Speicher nach Anspruch 1, wobei die Bitleitung durch den auf der Bitleitung angeordneten Leseverstärker in zwei Abschnitte unterteilt ist, ein Abschnitt mit einem positiven Eingang des Leseverstärkers verbunden ist und der andere Abschnitt mit einem negativen Eingang des Leseverstärkers verbunden ist.

3. Speicher nach Anspruch 1 oder 2, wobei ein Steuerende der Schalteinheit mit einer Wortleitung verbunden ist und die Schalteinheit bei Einschalten der Schalteinheit durch ein Steuersignal des Steuerendes dazu konfiguriert ist, einen Leseverstärker in einer vorherigen Reihe und einen Leseverstärker in einer nächsten Reihe zu leiten, um Daten zwischen dem Leseverstärker in der vorherigen Reihe und dem Leseverstärker in der nächsten Reihe zu übertragen.

4. Speicher nach Anspruch 3, wobei die Schalteinheit einen Schalttransistor umfasst und eine Source des Schalttransistors und ein Drain des Schalttransistors jeweils mit Bitleitungen der benachbarten Speicherzellen-Subarrays verbunden sind.

5. Speicher nach Anspruch 3, ferner umfassend eine Wortleitungs-Steuerschaltung, wobei die Wortleitungs-Steuerschaltung durch die Wortleitung hindurch mit dem Steuerende der Schalteinheit verbunden ist und dazu konfiguriert ist, das Steuersignal in das Steuerende der Schalteinheit einzugeben.

6. Speicher nach einem der Ansprüche 1 bis 5, wobei der Leseverstärker die Schalteinheit umfasst.

7. Speicher nach einem der Ansprüche 1 bis 6, wobei die Speicherzelle einen Zugriffstransistor und einen Speicherkondensator umfasst, ein Ende des Speicherkondensators mit einer Source-Leitung verbunden ist, das andere Ende des Speicherkondensators mit einem ersten Ende des Zugriffstransistors verbunden ist, ein zweites Ende des Zugriffstransistors mit der Bitleitung verbunden ist und ein Steuerende des Zugriffstransistors mit der Wortleitung verbunden ist.

8. Datenmigrationsverfahren für den Speicher nach einem der Ansprüche 1 bis 7, umfassend:
Lesen von Daten einer ersten Speicherzelle in einem ersten Speicherzellen-Subarray durch einen ersten Leseverstärker,
wobei ein erstes Ende des ersten Leseverstärkers durch eine erste Bitleitung hindurch mit der ersten Speicherzelle verbunden ist;
Steuern einer einzuschaltenden Schalteinheit und Schreiben der Daten der ersten Speicherzelle in einen zweiten Leseverstärker, wobei ein erstes Ende der Schalteinheit durch die erste Bitleitung hindurch mit dem ersten Ende des ersten Leseverstärkers verbunden ist und ein zweites Ende der Schalteinheit durch eine zweite Bitleitung hindurch mit einem zweiten Ende des zweiten Leseverstärkers verbunden ist; und
Schreiben der Daten der ersten Speicherzelle durch den zweiten Leseverstärker in eine zweite Speicherzelle in einem zweiten Speicherzellen-Subarray, wobei das zweite Ende des zweiten Leseverstärkers durch die zweite Bitleitung hindurch mit der zweiten Speicherzelle verbunden ist, wobei
das erste Ende des ersten Leseverstärkers ein positiver Eingang ist und das zweite Ende des zweiten Leseverstärkers ein negativer Eingang ist; oder das erste Ende des ersten Leseverstärkers ein negativer Eingang ist und das zweite Ende des zweiten Leseverstärkers ein positiver Eingang ist.

9. Verfahren nach Anspruch 8, wobei die erste Speicherzelle ferner mit einer ersten Wortleitung verbunden ist und das Verfahren vor dem Lesen von Daten einer ersten Speicherzelle in einem ersten Speicherzellen-Subarray durch einen ersten Leseverstärker ferner Folgendes umfasst:
Aktivieren der ersten Wortleitung.

10. Verfahren nach Anspruch 8 oder 9, wobei die zweite Speicherzelle ferner mit einer zweiten Wortleitung verbunden ist und das Verfahren vor dem Schreiben der Daten der ersten Speicherzelle durch den zweiten Leseverstärker in eine zweite Speicherzelle in einem zweiten Speicherzellen-Subarray ferner Folgendes umfasst:
Aktivieren der zweiten Wortleitung.

11. Integrierte Schaltung, die auf den Speicher nach einem der Ansprüche 1 bis 7 angewendet wird und eine Speichersteuerung und eine Speicherschnittstelle umfasst, wobei
die Speichersteuerung dazu konfiguriert ist: Daten einer ersten Speicherzelle in einem ersten Speicherzellen-Subarray unter Verwendung eines ersten Leseverstärkers zu lesen, wobei ein erstes Ende des ersten Leseverstärkers durch eine erste Bitleitung hindurch mit der ersten Speicherzelle verbunden ist; das Einschalten einer einzuschaltenden Schalteinheit zu steuern und die Daten der ersten Speicherzelle in einen zweiten Leseverstärker zu schreiben, wobei ein erstes Ende der Schalteinheit durch die erste Bitleitung hindurch mit dem ersten Ende des ersten Leseverstärkers verbunden ist und ein zweites Ende der Schalteinheit durch eine zweite Bitleitung hindurch mit einem zweiten Ende des zweiten Leseverstärkers verbunden ist; und die Daten der ersten Speicherzelle in eine zweite Speicherzelle in einem zweiten Speicherzellen-Subarray unter Verwendung des zweiten Leseverstärkers zu schreiben, wobei das zweite Ende des zweiten Leseverstärkers durch die zweite Bitleitung hindurch mit der zweiten Speicherzelle verbunden ist; und das erste Ende des ersten Leseverstärkers ein positiver Eingang ist und das zweite Ende des zweiten Leseverstärkers ein negativer Eingang ist; oder das erste Ende des ersten Leseverstärkers ein negativer Eingang ist und das zweite Ende des zweiten Leseverstärkers ein positiver Eingang ist.

12. Integrierte Schaltung nach Anspruch 11, wobei die erste Speicherzelle ferner mit einer ersten Wortleitung verbunden ist und die Speichersteuerung ferner dazu konfiguriert ist: die erste Wortleitung vor dem Lesen der Daten der ersten Speicherzelle in dem ersten Speicherzellen-Subarray unter Verwendung des ersten Leseverstärkers zu aktivieren.

13. Integrierte Schaltung nach Anspruch 11 oder 12, wobei die zweite Speicherzelle ferner mit einer zweiten Wortleitung verbunden ist und die Speichersteuerung ferner dazu konfiguriert ist: die zweite Wortleitung vor dem Schreiben der Daten der ersten Speicherzelle in die zweite Speicherzelle in dem zweiten Speicherzellen-Subarray unter Verwendung des zweiten Leseverstärkers zu aktivieren.

14. Integrierte Schaltung nach einem der Ansprüche 11 bis 13, wobei die Speichersteuerung ferner dazu konfiguriert ist: die Schalteinheit nach dem Schreiben der Daten der ersten Speicherzelle in die zweite Speicherzelle in dem zweiten Speicherzellen-Subarray unter Verwendung des zweiten Leseverstärkers auszuschalten; und die erste Bitleitung und die zweite Bitleitung vorzuladen.

15. Elektronische Vorrichtung, umfassend die integrierte Schaltung nach einem der Ansprüche 11 bis 14 und den Speicher nach einem der Ansprüche 1 bis 7, wobei die integrierte Schaltung eine Speichersteuerung und eine Speicherschnittstelle umfasst und der Speicher durch die Speicherschnittstelle hindurch mit der Speichersteuerung verbunden ist.

## Revendications

1. Mémoire, comprenant plusieurs banques de mémoire, dans laquelle la banque comprend une pluralité de sous-réseaux de cellules de mémoire disposés dans une colonne, chaque sous-réseau de cellules de mémoire comprend des cellules de mémoire disposées dans un réseau, des cellules de mémoire situées dans une même rangée dans le sous-réseau de cellules de mémoire sont connectées à une même ligne de mots et des cellules de mémoire situées dans une même colonne sont connectées à une même ligne de bits ;
un amplificateur de détection et une unité de commutation sont disposés en rangée à des espacements entre des sous-réseaux de cellules de mémoire adjacents, et entre des sous-réseaux de cellules de mémoire adjacents, un amplificateur de détection est disposé sur une ligne de bits de toutes les deux lignes de bits adjacentes et l'autre ligne de bits est connectée à une unité de commutation en série ; et
sur une même ligne de bits, l'amplificateur de détection et l'unité de commutation sont disposés en alternance entre les sous-réseaux de cellules de mémoire.

2. Mémoire selon la revendication 1, dans laquelle la ligne de bits est divisée en deux sections par l'amplificateur de détection disposé sur la ligne de bits, une section est connectée à une entrée positive de l'amplificateur de détection et l'autre section est connectée à une entrée négative de l'amplificateur de détection.

3. Mémoire selon la revendication 1 ou 2, dans laquelle une extrémité de commande de l'unité de commutation est connectée à une ligne de mots, et lorsque l'unité de commutation est activée par un signal de commande de l'extrémité de commande, l'unité de commutation est configurée pour conduire un amplificateur de détection dans une rangée précédente et un amplificateur de détection dans une rangée suivante afin de transmettre des données entre l'amplificateur de détection dans la rangée précédente et l'amplificateur de détection dans la rangée suivante.

4. Mémoire selon la revendication 3, dans laquelle l'unité de commutation comprend un transistor de commutation, et une source du transistor de commutation et un drain du transistor de commutation sont respectivement connectés aux lignes de bits des sous-réseaux de cellules de mémoire adjacents.

5. Mémoire selon la revendication 3, comprenant également un circuit de commande de ligne de mots, dans laquelle le circuit de commande de ligne de mots est connecté à l'extrémité de commande de l'unité de commutation par l'intermédiaire de la ligne de mots, et est configuré pour entrer le signal de commande dans l'extrémité de commande de l'unité de commutation.

6. Mémoire selon l'une quelconque des revendications 1 à 5, dans laquelle l'amplificateur de détection comprend l'unité de commutation.

7. Mémoire selon l'une quelconque des revendications 1 à 6, dans laquelle la cellule de mémoire comprend un transistor d'accès et un condensateur de stockage, une extrémité du condensateur de stockage est connectée à une ligne de source, l'autre extrémité du condensateur de stockage est connectée à une première extrémité du transistor d'accès, une seconde extrémité du transistor d'accès est connectée à la ligne de bit, et une extrémité de commande du transistor d'accès est connectée à la ligne de mot.

8. Procédé de migration de données pour la mémoire selon l'une quelconque des revendications 1 à 7, comprenant :
le fait de lire, par un premier amplificateur de détection, des données d'une première cellule de mémoire dans un premier sous-réseau de cellules de mémoire, dans lequel une première extrémité du premier amplificateur de détection est connectée à la première cellule de mémoire par l'intermédiaire d'une première ligne de bits ;
le fait de commander la mise sous tension d'une unité de commutation et le fait d'écrire les données de la première cellule de mémoire dans un second amplificateur de détection, dans lequel une première extrémité de l'unité de commutation est connectée à la première extrémité du premier amplificateur de détection par l'intermédiaire de la première ligne de bits, et une seconde extrémité de l'unité de commutation est connectée à une seconde extrémité du second amplificateur de détection par l'intermédiaire d'une seconde ligne de bits ; et
l'écriture, par le second amplificateur de détection, des données de la première cellule de mémoire dans une seconde cellule de mémoire dans un second sous-réseau de cellules de mémoire, dans lequel la seconde extrémité du second amplificateur de détection est connectée à la seconde cellule de mémoire par l'intermédiaire de la seconde ligne de bits, dans lequel
la première extrémité du premier amplificateur de détection est une entrée positive, et la seconde extrémité du second amplificateur de détection est une entrée négative ; ou la première extrémité du premier amplificateur de détection est une entrée négative, et la seconde extrémité du second amplificateur de détection est une entrée positive.

9. Procédé selon la revendication 8, dans lequel la première cellule de mémoire est également connectée à une première ligne de mots, et avant la lecture, par un premier amplificateur de détection, de données d'une première cellule de mémoire dans un premier sous-réseau de cellules de mémoire, le procédé comprend également :
l'activation de la première ligne de mots.

10. Procédé selon la revendication 8 ou 9, dans lequel la seconde cellule de mémoire est également connectée à une seconde ligne de mots, et avant l'écriture, par le second amplificateur de détection, des données de la première cellule de mémoire dans une seconde cellule de mémoire dans un second sous-réseau de cellules de mémoire, le procédé comprend également :
l'activation de la seconde ligne de mots.

11. Circuit intégré, appliqué à la mémoire selon l'une quelconque des revendications 1 à 7, et comprenant un dispositif de commande de mémoire et une interface de mémoire, dans lequel
le dispositif de commande de mémoire est configuré pour : lire des données d'une première cellule de mémoire dans un premier sous-réseau de cellules de mémoire en utilisant un premier amplificateur de détection, dans lequel une première extrémité du premier amplificateur de détection est connectée à la première cellule de mémoire par l'intermédiaire d'une première ligne de bits ; commander une unité de commutation pour qu'elle soit mise sous tension, et écrire les données de la première cellule de mémoire dans un second amplificateur de détection, dans lequel une première extrémité de l'unité de commutation est connectée à la première extrémité du premier amplificateur de détection par l'intermédiaire de la première ligne de bits, et une seconde extrémité de l'unité de commutation est connectée à une seconde extrémité du second amplificateur de détection par l'intermédiaire d'une seconde ligne de bits ; et écrire les données de la première cellule de mémoire dans une seconde cellule de mémoire dans un second sous-réseau de cellules de mémoire en utilisant le second amplificateur de détection, dans lequel la seconde extrémité du second amplificateur de détection est connectée à la seconde cellule de mémoire par l'intermédiaire de la seconde ligne de bits ; et la première extrémité du premier amplificateur de détection est une entrée positive, et la seconde extrémité du second amplificateur de détection est une entrée négative ; ou la première extrémité du premier amplificateur de détection est une entrée négative, et la seconde extrémité du second amplificateur de détection est une entrée positive.

12. Circuit intégré selon la revendication 11, dans lequel la première cellule de mémoire est également connectée à une première ligne de mots, et le dispositif de commande de mémoire est également configuré pour : avant de lire les données de la première cellule de mémoire dans le premier sous-réseau de cellules de mémoire en utilisant le premier amplificateur de détection, activer la première ligne de mots.

13. Circuit intégré selon la revendication 11 ou 12, dans lequel la seconde cellule de mémoire est également connectée à une seconde ligne de mots, et le dispositif de commande de mémoire est également configuré pour : avant d'écrire les données de la première cellule de mémoire dans la seconde cellule de mémoire dans le sous-réseau de seconde cellule de mémoire en utilisant le second amplificateur de détection, activer la seconde ligne de mots.

14. Circuit intégré selon l'une quelconque des revendications 11 à 13, dans lequel le dispositif de commande de mémoire est également configuré pour : après avoir écrit les données de la première cellule de mémoire dans la seconde cellule de mémoire dans le second sous-réseau de cellules de mémoire en utilisant le second amplificateur de détection, mettre l'unité de commutation hors tension ; et précharger la première ligne de bits et la seconde ligne de bits.

15. Dispositif électronique, comprenant le circuit intégré selon l'une quelconque des revendications 11 à 14 et la mémoire selon l'une quelconque des revendications 1 à 7, dans lequel le circuit intégré comprend un dispositif de commande de mémoire et une interface de mémoire, et la mémoire est connectée au dispositif de commande de mémoire par l'intermédiaire de l'interface de mémoire.
